# FASCICULE DE BREVET EUROPEEN

(11) **EP 4 099 397 B1**
(45) Date de publication et mention de la délivrance du brevet: **12.08.2026**
(21) Numéro de dépôt: 22175278.5
(22) Date de dépôt: 25.05.2022
(51) Int. Cl.: H10D 1/40, H10D 12/01, H10D 30/01, H10D 30/60, H10D 48/01, H10D 62/824, H10D 62/832, H10D 62/85, H10D 84/01, H10D 84/08, H10D 84/82

(54) **DISPOSITIF ÉLECTRONIQUE À TRANSISTORS**
ELEKTRONISCHE VORRICHTUNG MIT TRANSISTOREN
ELECTRONIC TRANSISTOR DEVICE

(30) Priorité: 04.06.2021 FR 2105886
(43) Date de publication de la demande: 07.12.2022
(73) Titulaire: Commissariat à l'Energie Atomique et aux Energies Alternatives, 75015 Paris (FR)
(72) Inventeur: ESCOFFIER, René, 38054 GRENOBLE CEDEX 09 (FR); MOHAMAD, Blend, 38054 GRENOBLE CEDEX 09 (FR)
(74) Mandataire: Cabinet Beaumont

(56) Documents cités:
- WO-A1-2017/213644

## Description

### Domaine technique

La présente description concerne de façon générale les dispositifs électroniques. La présente description concerne plus particulièrement les transistors à haute mobilité électronique (« High-Electron-Mobility Transistor » - HEMT, en anglais), ou transistors HEMT, et notamment les transistors HEMT normalement bloqués à base de nitrure de gallium (GaN) et les procédés de réalisation de tels transistors.

### Technique antérieure

Des transistors HEMT normalement bloqués à base de nitrure de gallium sont couramment utilisés par exemple dans des applications de conversion d'énergie électrique, pour des puissances typiquement comprises entre quelques milliwatts et plusieurs dizaines de watts. Il existe différents types de transistors HEMT normalement bloqués, notamment des transistors HEMT à grille isolée de type métal-isolant-semiconducteur (« Metal-Insulator-Semiconductor » - MIS, en anglais), ou transistors MIS-HEMT. De tels transistors présentent généralement une faible tension de seuil et une forte résistance à l'état passant, ce qui nuit à leurs performances.

Le document WO 2017/213644 décrit une intégration monolithique d'un transistor à canal P d'arrière-plan avec un transistor à canal N de type III-N.

### Résumé de l'invention

Il existe un besoin d'améliorer les transistors à haute mobilité électronique normalement bloqués à base de nitrure de gallium existants.

Un mode de réalisation pallie tout ou partie des inconvénients des transistors à haute mobilité électronique normalement bloqués à base de nitrure de gallium existants.

L'invention est définie dans les revendications annexées.

Un mode de réalisation prévoit un dispositif électronique comportant :
- une région semiconductrice située sur une couche en nitrure de gallium ;
- deux électrodes, situées de part et d'autre et isolées de la région semiconductrice, les électrodes pénétrant partiellement dans la couche en nitrure de gallium ; et
- deux transistors MOS latéraux formés dans et sur la région semiconductrice.

Selon un mode de réalisation, chaque transistor est configuré pour commander le passage d'un courant électrique entre l'une desdites électrodes et une ou plusieurs deuxièmes électrodes portées par la région semiconductrice.

Selon un mode de réalisation, chaque transistor comprend une région de grille située à l'aplomb d'une région de canal comprise entre des régions de source et de drain formées dans la région semiconductrice.

Selon un mode de réalisation, les régions de source des transistors sont dopées d'un premier type de conductivité et séparées par un puits formé dans la région semiconductrice et dopé d'un deuxième type de conductivité, opposé au premier type de conductivité.

Selon un mode de réalisation, la région de drain de chaque transistor est reliée, par l'intermédiaire d'un gaz d'électrons bidimensionnel, à l'une desdites électrodes.

Selon un mode de réalisation, le dispositif comporte en outre une ou plusieurs régions conductrices contactant les régions de drain des transistors et pénétrant partiellement dans la couche en nitrure de gallium.

Selon un mode de réalisation, le dispositif comporte exactement deux régions conductrices revêtant des flancs opposés de la région semiconductrice situés en regard desdites électrodes et une seule deuxième électrode située entre les transistors.

Selon un mode de réalisation, le dispositif comporte exactement deux régions conductrices comprenant des vias conducteurs situés de part et d'autre de la région semiconductrice et une seule deuxième électrode située entre les transistors.

Selon un mode de réalisation non couvert par les revendications, le dispositif comporte une seule région conductrice comprenant un via conducteur traversant la région semiconductrice et exactement deux deuxièmes électrodes situées de part et d'autre des transistors.

Selon un mode de réalisation, la région semiconductrice pénètre partiellement à l'intérieur de la couche en nitrure de gallium.

Selon un mode de réalisation, une partie inférieure de la région semiconductrice est isolée de la couche en nitrure de gallium.

Selon un mode de réalisation, les premières électrodes sont destinées à être portées à un même potentiel.

Selon un mode de réalisation, la région semiconductrice est en un matériau différent de celui de la couche en nitrure de gallium, de préférence en silicium ou en carbure de silicium.

Un mode de réalisation prévoit un procédé de réalisation d'un dispositif tel que décrit, le procédé comprenant les étapes suivantes :
a) former une tranchée à l'intérieur de la couche en nitrure de gallium ;
b) former les premières électrodes de part et d'autre de la tranchée ;
c) remplir la tranchée par la région semiconductrice ; et
d) former les transistors MOS.

Selon un mode de réalisation, le procédé comprend en outre, après l'étape d), l'étape de former la ou les deuxièmes électrodes.

Selon un mode de réalisation, la ou les régions conductrices sont formées à l'étape b).

### Brève description des dessins

Ces caractéristiques et avantages, ainsi que d'autres, seront exposés en détail dans la description suivante de modes de réalisation et modes de mise en œuvre particuliers faite à titre non limitatif en relation avec les figures jointes parmi lesquelles :
la figure 1 est une vue en coupe, schématique et partielle, d'un exemple de transistor ;
la figure 2 est un schéma électrique équivalent au transistor de la figure 1 ;
la figure 3 est une vue en coupe, schématique et partielle, d'un dispositif électronique selon un premier mode de réalisation ;
la figure 4 est un schéma électrique équivalent au dispositif électronique de la figure 3 ;
la figure 5 est une vue en coupe, schématique et partielle, d'un dispositif électronique selon un deuxième mode de réalisation ;
la figure 6 est une vue en coupe, schématique et partielle, d'un dispositif électronique selon un troisième mode de réalisation ;
la figure 7 est une vue en coupe, schématique et partielle, d'un dispositif électronique selon un quatrième mode de réalisation non couvert par les revendications ;
la figure 8 est une vue en coupe, schématique et partielle, illustrant une étape d'un mode de mise en œuvre d'un procédé de réalisation du dispositif électronique de la figure 3 ;
la figure 9 est une vue en coupe, schématique et partielle, illustrant une étape ultérieure du mode de mise en œuvre du procédé de réalisation du dispositif électronique de la figure 3 ;
la figure 10 est une vue en coupe, schématique et partielle, illustrant encore une étape ultérieure du mode de mise en œuvre du procédé de réalisation du dispositif électronique de la figure 3 ;
la figure 11 est une vue en coupe, schématique et partielle, illustrant encore une étape ultérieure du mode de mise en œuvre du procédé de réalisation du dispositif électronique de la figure 3 ;
la figure 12 est une vue en coupe, schématique et partielle, illustrant encore une étape ultérieure du mode de mise en œuvre du procédé de réalisation du dispositif électronique de la figure 3 ;
la figure 13 est une vue en coupe, schématique et partielle, illustrant encore une étape ultérieure du mode de mise en œuvre du procédé de réalisation du dispositif électronique de la figure 3 ;
la figure 14 est une vue en coupe, schématique et partielle, illustrant encore une étape ultérieure du mode de mise en œuvre du procédé de réalisation du dispositif électronique de la figure 3 ; et
la figure 15 est une vue en coupe, schématique et partielle, illustrant encore une étape ultérieure du mode de mise en œuvre du procédé de réalisation du dispositif électronique de la figure 3.

### Description des modes de réalisation

Dans la description qui suit, divers exemples, modes de réalisation et variantes sont exposés. Nonobstant la façon dont ils sont nommés, seuls font partie de la présente invention ceux couverts par les revendications.

De mêmes éléments ont été désignés par de mêmes références dans les différentes figures. En particulier, les éléments structurels et/ou fonctionnels communs aux différents modes de réalisation et modes de mise en œuvre peuvent présenter les mêmes références et peuvent disposer de propriétés structurelles, dimensionnelles et matérielles identiques.

Par souci de clarté, seuls les étapes et éléments utiles à la compréhension des modes de réalisation et modes de mise en œuvre décrits ont été représentés et sont détaillés. En particulier, les applications et systèmes susceptibles de tirer profit des dispositifs électroniques décrits ne sont pas détaillés, les modes de réalisation et modes de mise en œuvre de la présente description étant notamment compatibles avec les applications et systèmes usuels comportant des transistors normalement bloqués à haute mobilité électronique à base de nitrure de gallium.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près, ou, lorsqu'il s'agit de valeurs angulaires, à 10° près, de préférence à 5° près.

Dans la description qui suit, sauf précision contraire, les termes isolant et conducteur signifient respectivement électriquement isolant et électriquement conducteur.

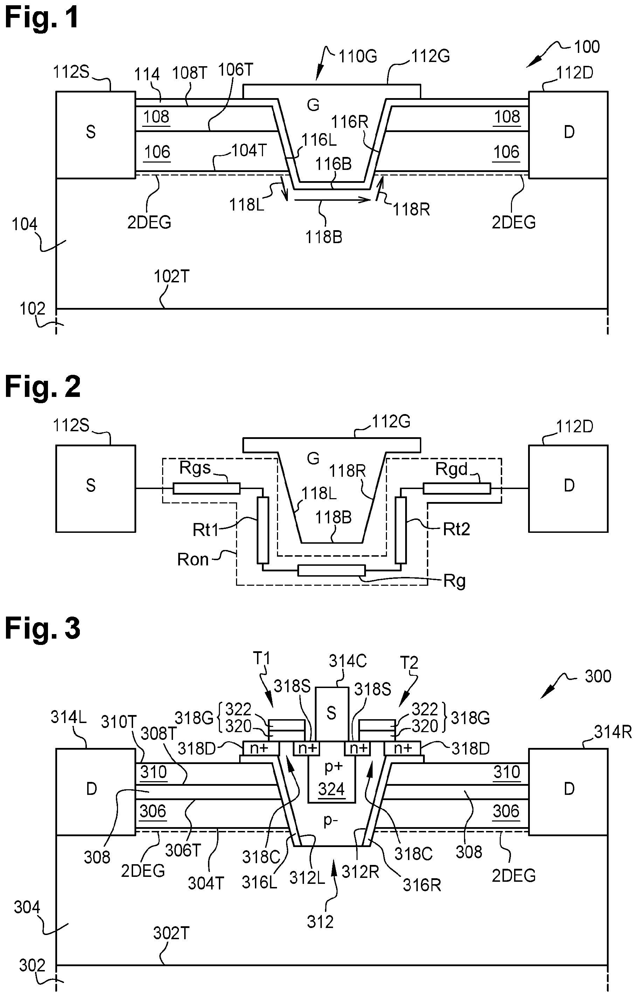

La figure 1 est une vue en coupe, schématique et partielle, d'un exemple de transistor 100 à haute mobilité électronique (« High-Electron-Mobility Transistor » - HEMT, en anglais), ou transistor HEMT. Le transistor HEMT 100 est, dans cet exemple, normalement bloqué.

Dans l'exemple représenté, le transistor HEMT 100 est formé sur un substrat 102, par exemple une plaquette ou un morceau de plaquette dont seule une partie est représentée en figure 1. À titre d'exemple, le substrat 102 est en un matériau semiconducteur, par exemple le silicium, en saphir, etc.

Dans l'orientation de la figure 1, une couche 104 revêt une face supérieure 102T du substrat 102. À titre d'exemple, la couche 104 est en nitrure de gallium (GaN), par exemple en nitrure de gallium intrinsèque c'est-à-dire non dopé de manière intentionnelle.

Dans l'exemple représenté, une autre couche 106, par exemple en nitrure d'aluminium-gallium (AlGaN), revêt une face supérieure 104T de la couche 104 et encore une autre couche 108, par exemple en nitrure de silicium (SiN), revêt une face supérieure 106T de la couche 106.

Le transistor 100 comporte une région 110G de grille. La région 110G de grille du transistor 100 est dite encastrée (« recessed », en anglais) dans la couche 104 en nitrure de gallium. Plus précisément, dans l'exemple représenté, la région 110G de grille s'étend verticalement, depuis une face supérieure 108T de la couche 108, en direction de la face supérieure 102T du substrat 102. Chaque couche 106, 108 comporte ainsi deux parties disjointes, situées de part et d'autre de la région 110G de grille.

Dans l'exemple représenté, la région 110G de grille du transistor 100 comporte une électrode 112G de grille (G). L'électrode 112G présente une section en forme de T, dont une partie verticale traverse les couches 108 et 106 et pénètre partiellement dans l'épaisseur de la couche 104 et dont une partie horizontale s'étend au-dessus de la couche 108.

Dans l'exemple représenté, les flancs de la partie verticale du T formé par l'électrode 112G de grille sont inclinés de telle sorte qu'ils se rapprochent l'un de l'autre en bas de l'électrode 112G. Cela permet de faciliter le passage des électrons d'un côté à l'autre de l'électrode 112G.

L'électrode 112G de grille est en un matériau conducteur. À titre d'exemple, l'électrode 112G est en un métal ou en un alliage métallique, par exemple un alliage à base de nitrure de titane (TiN) et de tungstène (W).

Dans l'exemple représenté, encore une autre couche 114 isole l'électrode 112G des couches 104, 106 et 108. La couche 114 est en un matériau isolant, par exemple l'alumine (Al₂O₃).

La couche isolante 114 revêt des faces latérales 116L, 116R, ou parois, et une face inférieure 116B, ou fond, de la partie verticale du T formé par l'électrode 112G. En outre, la couche isolante 114 se prolonge latéralement de part et d'autre de la partie verticale et sous la partie horizontale du T formé par l'électrode 112G. La couche 114 s'étend sur et en contact avec la face supérieure 108T de la couche 108.

Dans l'exemple représenté, la partie horizontale du T formé par l'électrode 112G s'étend sur et en contact avec des parties de la couche 114. Ces parties de la couche 114 sont ainsi intercalées verticalement entre la couche 108 et la partie horizontale du T formé par l'électrode 112G.

Les parties de la couche 114 situées à l'aplomb de l'électrode 112G de grille peuvent être considérées comme faisant partie de la région 110G de grille du transistor 100.

Dans l'exemple représenté, la couche isolante 114 présente une épaisseur sensiblement constante. À titre d'exemple, l'épaisseur de la couche 114 est égale à environ 30 nm, à plus ou moins 20 % près. Cela permet d'isoler convenablement l'électrode 112G de grille par rapport à la couche 104 en nitrure de gallium tout en conservant une tension Vth de seuil relativement faible, par exemple de l'ordre de 1 V.

Le transistor 100 comporte en outre deux autres électrodes 112S et 112D. Les électrodes 112S et 112D sont situées de part et d'autre de l'électrode 112G de grille du transistor 100. L'électrode 112S est par exemple plus proche de l'électrode 112G de grille que l'électrode 112D. Les électrodes 112S, 112G et 112D du transistor 100 s'étendent perpendiculairement au plan de coupe de la figure 1, le long d'une direction communément appelée largeur (W) du transistor 100. Le plan de coupe de la figure 1 est ainsi orienté parallèlement à une autre direction communément appelée longueur (L) du transistor 100 et perpendiculairement à la face supérieure 108T de la couche 108.

À titre d'exemple :
- l'électrode 112S est séparée de l'électrode 112G par une distance comprise entre 1 et 2 µm, par exemple égale à environ 1 µm ; et
- l'électrode 112D est séparée de l'électrode 112G par une distance comprise entre 10 et 20 µm, par exemple égale à environ 10 µm, dans le but d'assurer une tenue en tension par exemple jusqu'à 1 000 V (le nitrure de gallium de la couche 104 peut théoriquement supporter un champ électrique maximum de l'ordre de 2 MV/cm ; toutefois, ce champ est en pratique limité à environ 1 MV/cm en raison de défauts présents dans la couche 104).

Dans l'exemple représenté, les électrodes 112S et 112D s'étendent chacune verticalement, depuis la face supérieure de la couche isolante 114, en direction de la face supérieure 102T du substrat 102. Plus précisément, dans l'exemple représenté, les électrodes 112S et 112D traversent chacune les couches 114, 108 et 106 et pénètrent partiellement dans l'épaisseur de la couche 104.

Les électrodes 112S et 112D sont chacune en un matériau conducteur, par exemple un métal ou un alliage métallique. Les électrodes 112S et 112D sont par exemple en le même matériau que l'électrode 112G.

À titre d'exemple, lorsque le transistor 100 est en fonctionnement, l'électrode 112S est une électrode de source (S) et l'électrode 112D est une électrode de drain (D). L'électrode 112D étant plus éloignée de l'électrode 112G que l'électrode 112S, cela permet d'appliquer un potentiel élevé, par exemple de l'ordre de 650 V, sur l'électrode 112D sans risque de claquage du transistor 100, les électrodes 112S et 112G étant généralement soumises à des potentiels de l'ordre de quelques volts.

Dans le transistor HEMT 100, un gaz d'électrons bidimensionnel 2DEG, symbolisé en figure 1 par un trait en pointillé, se forme à l'intérieur de la couche 104 à proximité d'une interface entre les couches 104 et 106. Les électrodes 112S et 112D du transistor HEMT 100 sont chacune en contact avec le gaz d'électrons bidimensionnel 2DEG.

Dans l'exemple représenté où le transistor HEMT 100 est normalement bloqué, le gaz d'électrons bidimensionnel 2DEG est interrompu par la région 110G de grille. Plus précisément, dans cet exemple, le gaz d'électrons bidimensionnel 2DEG est discontinu et comporte deux parties situées de part et d'autre de la région 110G de grille du transistor 100 (à gauche et à droite de la région 110G, dans l'orientation de la figure 1).

Lorsqu'une tension Vgs inférieure à la tension Vth de seuil du transistor 100, par exemple sensiblement nulle, est appliquée entre l'électrode 112G de grille et l'électrode 112S de source, la région 110G de grille encastrée dans la couche 104 en nitrure de gallium empêche les électrons de circuler entre l'électrode 112S de source et l'électrode 112D de drain. Le transistor 100 est alors dans un état bloqué.

En revanche, lorsque la tension Vgs appliquée entre l'électrode 112G de grille et l'électrode 112S de source excède la tension Vth de seuil du transistor 100, des électrons peuvent circuler entre l'électrode 112S de source et l'électrode 112D de drain. Le transistor 100 est alors dans un état passant.

À l'état passant, les électrons circulent d'une partie à l'autre du gaz d'électrons bidimensionnel 2DEG en contournant la région 110G de grille. Plus précisément, lorsque le transistor 100 est passant et soumis à une tension de polarisation appliquée entre son drain D et sa source S, les électrons empruntent alors, pour circuler d'un côté à l'autre de la grille G, un chemin de conduction situé à l'intérieur de la couche 104 le long d'une interface entre la couche 104 et la couche isolante 114.

Le chemin de conduction emprunté par les électrons pour contourner la région 110G de grille est symbolisé, en figure 1, par des flèches 118L, 118B et 118R. Plus précisément, dans l'orientation de la figure 1 :
- la flèche 118L symbolise un chemin emprunté par les électrons pour descendre le long du flanc 116L de l'électrode 112G de grille situé côté électrode 112S de source ;
- la flèche 118B symbolise un chemin emprunté par les électrons pour se déplacer horizontalement sous le fond 116B de l'électrode 112G de grille ; et
- la flèche 118R symbolise un chemin emprunté par les électrons pour remonter le long de l'autre flanc 116R de l'électrode 112G de grille opposé au flanc 116L, situé côté électrode 112D de drain.

Bien que cela n'ait pas été représenté en figure 1, le transistor 100 peut en outre comporter d'autres éléments tels que des couches isolantes revêtant la couche 114 et/ou une partie de l'électrode 112G de grille, des plaques de champ (« field plates », en anglais), des éléments de reprise de contact, etc.

Un inconvénient des transistors HEMT semblables au transistor 100 tient au fait qu'ils présentent, à l'état passant, une résistance drain-source Ron élevée qui dégrade fortement leurs performances électriques. Cela est notamment dû à des résistances associées aux chemins de conduction 118L, 118B et 118R empruntés par les électrons pour contourner la région 110G de grille, qui sont à l'origine d'une baisse de mobilité des électrons.

Un autre inconvénient de ces transistors provient de défauts présents à l'intérieur de la couche 104 en nitrure de gallium et qui induisent, sur les chemins de conduction 118L, 118B et 118R, un piégeage des électrons. Cela provoque, de façon indésirable, un phénomène d'hystérésis observable en mesurant des variations de courant Id de drain en fonction de la tension grille-source Vgs (courbes Id(Vgs)) ainsi qu'un phénomène d'atténuation du courant Id de drain après polarisation du transistor, également appelé phénomène d'effondrement du courant (« current collapse », en anglais).

Afin de diminuer la résistance Ron à l'état passant du transistor 100, on pourrait penser prévoir une structure dans laquelle la couche isolante 114 serait omise et où l'électrode 112G de grille ne pénètrerait pas à l'intérieur de la couche 104 en nitrure de gallium. Cela reviendrait par exemple à faire en sorte que l'électrode 112G s'arrête dans l'épaisseur de la couche 106, avant l'interface entre la couche 106 et la couche 104. On formerait ainsi une grille de type Schottky, qui permettrait d'interrompre ou d'atténuer localement le gaz d'électrons bidimensionnel 2DEG à l'aplomb de l'électrode 112G de grille de sorte à obtenir un transistor normalement bloqué. Toutefois, cela ne permettrait pas d'atteindre une tension Vth de seuil supérieure à environ 1 V, ce qui s'avère problématique pour la plupart des applications utilisant des transistors HEMT.

On pourrait en outre penser réaliser une structure dans laquelle la région 110G de grille ne serait pas encastrée dans les couches 108, 106 et 104. Cela reviendrait par exemple à former l'électrode 112G de grille sur et en contact avec la couche 108. À titre d'exemple, on pourrait notamment prévoir une implantation d'ions fluor (F⁺) dans la couche 106, à l'aplomb de l'électrode 112G de grille, ce qui aurait pour effet d'atténuer ou d'interrompre le gaz d'électrons bidimensionnel 2DEG sous la grille du transistor 100. Cela tendrait toutefois à compliquer un contrôle de la tension Vth de seuil.

On pourrait alternativement prévoir d'omettre la couche 114, de réaliser l'électrode 112G de grille au-dessus de la couche 108 et d'intercaler une couche en nitrure de gallium dopé de type P (p-GaN) entre l'électrode de grille et la couche 108. Toutefois, cela ne permettrait pas d'atteindre une tension Vth de seuil suffisamment élevée pour les applications visées.

On pourrait par ailleurs penser réduire la largeur de la face inférieure 116B de la partie verticale du T formé par la région 110G de grille, de manière à réduire la longueur du chemin de conduction horizontal 118B. Toutefois, cela ne permettrait pas de diminuer significativement la résistance Ron à l'état passant du transistor 100.

La figure 2 est un schéma électrique équivalent au transistor 100 de la figure 1.

Comme illustré en figure 2, la résistance Ron à l'état passant du transistor 100, entre sa borne 112S de source et sa borne 112D de drain, peut être décomposée en :
- une résistance Rgs, correspondant à un chemin de conduction empruntant la partie du gaz d'électrons bidimensionnel 2DEG située entre l'électrode 112S de source et l'électrode 112G de grille ;
- une autre résistance Rt1, correspondant au chemin de conduction 118L emprunté par les électrons pour descendre le long du flanc 116L de l'électrode 112G ;
- encore une autre résistance Rg, correspondant au chemin de conduction 118B emprunté par les électrons pour se déplacer horizontalement sous le fond 116B de l'électrode 112G ;
- encore une autre résistance Rt2 correspondant au chemin de conduction 118R emprunté par les électrons pour remonter le long du flanc 116R de l'électrode 112G ; et
- encore une autre résistance Rgd, correspondant à un chemin de conduction empruntant la partie du gaz d'électrons bidimensionnel 2DEG située entre l'électrode 112G de grille et l'électrode 112D de drain.

Les résistances Rgs, Rt1, Rg, Rt2 et Rgd, dont l'association en série équivaut à la résistance Ron en négligeant les résistances de contact ohmique de source et de drain, nuisent au fonctionnement du transistor 100 comme cela a été exposé précédemment en relation avec la figure 1. En particulier, les résistances Rt1 et Rt2 présentent généralement une valeur importante, qui impacte fortement la résistance Ron à l'état passant du transistor 100.

La figure 3 est une vue en coupe, schématique et partielle, d'un dispositif électronique 300 selon un premier mode de réalisation.

Le dispositif 300 est par exemple formé sur un substrat 302 semblable au substrat 102 précédemment décrit en relation avec la figure 1.

Dans l'orientation de la figure 3, une couche 304 revêt une face supérieure 302T du substrat 302. À titre d'exemple, la couche 304 est en nitrure de gallium (GaN), par exemple en nitrure de gallium intrinsèque c'est-à-dire non dopé de manière intentionnelle.

Dans l'exemple représenté :
- une autre couche 306, par exemple en nitrure d'aluminium-gallium (AlGaN), revêt une face supérieure 304T de la couche 304 ;
- encore une autre couche 308, par exemple une couche de passivation en nitrure de silicium (SiN), revêt une face supérieure 306T de la couche 306 ; et
- encore une autre couche 310, par exemple en alumine (A₂O₃), revêt une face supérieure 308T de la couche 308.

Selon un mode de réalisation, le dispositif 300 comporte une région semiconductrice 312, située sur la couche 304 en nitrure de gallium, et deux électrodes 314L (D) et 314R (D), situées de part et d'autre de la région semiconductrice 312. Dans l'exemple représenté, la région semiconductrice 312 et les électrodes 314L et 314R pénètrent partiellement à l'intérieur de la couche 304 en nitrure de gallium. Les électrodes 314L et 314R sont isolées de la région 312, autrement dit les électrodes 314L et 314R ne sont pas en contact avec la région 312. Chaque électrode 314L, 314R est par exemple séparée de la région 312 par une distance comprise entre 10 et 20 µm, par exemple égale à environ 10 µm, dans le but d'assurer une tenue en tension par exemple jusqu'à 1 000 V.

La région semiconductrice 312 est en un matériau différent de celui de la couche 304. La région 312 est de préférence en silicium (Si) ou en carbure de silicium (SiC).

Dans le dispositif 300, un gaz d'électrons bidimensionnel 2DEG, symbolisé en figure 3 par un trait en pointillé, est présent dans la couche 304 à proximité d'une interface entre les couches 304 et 306. Les électrodes 314L et 314R du dispositif 300 sont toutes les deux en contact avec le gaz d'électrons bidimensionnel 2DEG. Dans l'exemple représenté, le gaz d'électrons bidimensionnel 2DEG est interrompu par la région 312 et comporte ainsi deux parties situées de part et d'autre de la région 312 (à gauche et à droite de la région 312, dans l'orientation de la figure 3).

Dans l'exemple représenté, des flancs 312L et 312R de la région semiconductrice 312, situés respectivement en regard des électrodes 314L et 314R, sont revêtus de régions conductrices 316L et 316R. Les régions conductrices 316L et 316R s'étendent par exemple sur toute la hauteur des flancs 312L et 312R de la région semiconductrice 312 et se prolongent sur et en contact avec une face supérieure 310T de la couche 310. En particulier, dans cet exemple, les régions conductrices 316L et 316R pénètrent à l'intérieur de la couche 304 en nitrure de gallium et contactent chacune une partie du gaz d'électrons bidimensionnel 2DEG. Chaque partie du gaz d'électrons bidimensionnel 2DEG s'étend ainsi latéralement entre l'une des régions conductrices 316L, 316R et l'électrode 314L, 314R lui faisant face.

Selon un mode de réalisation, le dispositif 300 comporte en outre deux transistors T1 et T2 à effet de champ à grille isolée (« Metal-Oxide-Semiconductor Field-Effect Transistor » - MOSFET, en anglais), également appelés transistors MOSFET ou, plus simplement, transistors MOS. Les transistors T1 et T2 sont plus précisément des transistors MOS latéraux formés dans et sur la région semiconductrice 312. Dans l'exemple représenté, chaque transistor MOS T1, T2 comprend une région 318G de grille située à l'aplomb d'une région 318C de canal comprise entre une région 318S de source et une région 318D de drain. Les régions 318S et 318D sont formées dans la région semiconductrice 312. La région 318C est également située dans la région semiconductrice 312. La région 318G de grille de chaque transistor MOS T1, T2 comprend par exemple une région isolante 320, située sur et en contact avec une face supérieure de la région 312 au-dessus de la région 318C de canal, et une région conductrice 322 revêtant une face supérieure de la région isolante 320. Les régions 320 et 322 forment par exemple respectivement un isolant, ou oxyde, de grille et une électrode de grille du transistor MOS.

Les régions 318D de drain des transistors T1 et T2 sont respectivement situées sur et en contact avec des parties des régions conductrices 316L et 316R. De cette manière, les régions conductrices 316L et 316R permettent d'établir un contact électrique entre, d'une part, les régions 318D de drain des transistors T1 et T2 et, d'autre part, les parties du gaz d'électrons bidimensionnel situées du côté des électrodes 314L et 314R du dispositif 300. Les régions conductrices 316L et 316R présentent chacune une résistance sensiblement nulle, permettant ainsi avantageusement à des électrons de circuler facilement entre les parties du gaz d'électrons bidimensionnel 2DEG et les régions 318D de drain des transistors T1 et T2.

Dans l'exemple représenté, le dispositif 300 comporte en outre une autre électrode 314C (S) située entre les deux transistors MOS T1 et T2. L'électrode 314C est portée par la région semiconductrice 312. Plus précisément, dans cet exemple, l'électrode 314C est située sur et en contact avec la face supérieure de la région 312 à l'aplomb d'un puits 324 formé dans la région 312.

Les régions 318S de source et 318D de drain des transistors MOS T1 et T2 sont par exemple dopées d'un premier type de conductivité, par exemple le type n, tandis que le puits 324 et les autres parties de la région semiconductrice 312 sont par exemple dopées d'un deuxième type de conductivité opposé au premier type de conductivité, le type p dans cet exemple. Plus précisément, les régions 318S et 318D sont par exemple fortement dopées de type n (n+), tandis que le puits 324 est fortement dopé de type p (p+) et les parties restantes de la région 312 sont faiblement dopées de type p (p-). Dans ce cas, les régions 318C de canal des transistors MOS T1 et T2 sont faiblement dopées de type p. À titre de variante, le puits 324 peut toutefois être omis, l'électrode 314C étant alors directement en contact avec une partie de la région 312 faiblement dopée de type p.

Les électrodes 314L et 314R du dispositif 300 sont destinées à être portées à un même potentiel, par exemple égal à environ 650 V, tandis que l'électrode 314C est portée à un potentiel de référence, par exemple la masse (0 V). Les électrodes 314L et 314R sont par exemple assimilables à des électrodes de drain du dispositif 300 tandis que l'électrode 314C est assimilable à une électrode de source du dispositif 300.

Chaque transistor MOS T1, T2 est configuré pour commander le passage d'un courant électrique entre l'une des électrodes 314L, 314R et l'électrode 314C, par exemple en fonction d'un potentiel de commande appliqué sur l'électrode 322 de grille du transistor. Les transistors T1 et T2 sont par exemple commandés de façon simultanée par l'application, sur leurs électrodes de grille 322 respectives, d'un potentiel commun (par rapport à l'électrode de source 314C) permettant, selon sa valeur, d'interrompre ou d'établir le courant entre l'électrode 314L, 314R et l'électrode 314C.

Lorsque le transistor T1, T2 est dans un état passant, un courant électrique circule entre l'électrode 314L, 314R et l'électrode 314C. Ce courant électrique transite plus précisément :
- par la partie du gaz d'électrons bidimensionnel 2DEG située entre l'électrode 314L, 314R et la région conductrice 316L, 316R en regard de cette électrode ;
- par la région conductrice 316L, 316R ;
- par les régions 318D de drain, 318C de canal et 318S de source du transistor T1, T2 ; et
- par le puits 324.

Un avantage du dispositif 300 tient au fait qu'il permet de découpler la fonction de tenue en tension, réalisée par la distance séparant chaque électrode 314L, 314R de la région semiconductrice 312, et la fonction de commutation, réalisée par les transistors MOS latéraux T1 et T2. Cela permet au dispositif 300 de présenter un fonctionnement analogue à celui d'un transistor HEMT dont l'électrode de source correspondrait à l'électrode 314C, dont l'électrode de drain correspondrait aux électrodes 314L et 314R et dont la commande s'effectuerait en polarisant les électrodes 322 de grille des transistors MOS T1 et T2.

Du fait que la fonction de commutation est réalisée par les transistors MOS T1 et T2, qui présentent chacun une tension de seuil de l'ordre de 5 V, le dispositif 300 présente avantageusement une tension de seuil supérieure à celle du transistor HEMT 100 de la figure 1.

En outre, le dopage de type p (p+) du puits 324 permet avantageusement de former un bon contact ohmique, donc d'obtenir une faible résistance de contact, entre l'électrode 314C et la région 312. On améliore ainsi l'efficacité énergétique du dispositif 300 en réduisant sa résistance Ron à l'état passant.

Le dispositif 300 est également plus compact qu'un dispositif dans lequel au moins un transistor analogue aux transistors T1 et T2 serait situé en dehors de la région délimitée par les électrodes 314L et 314R, par exemple sur une puce séparée.

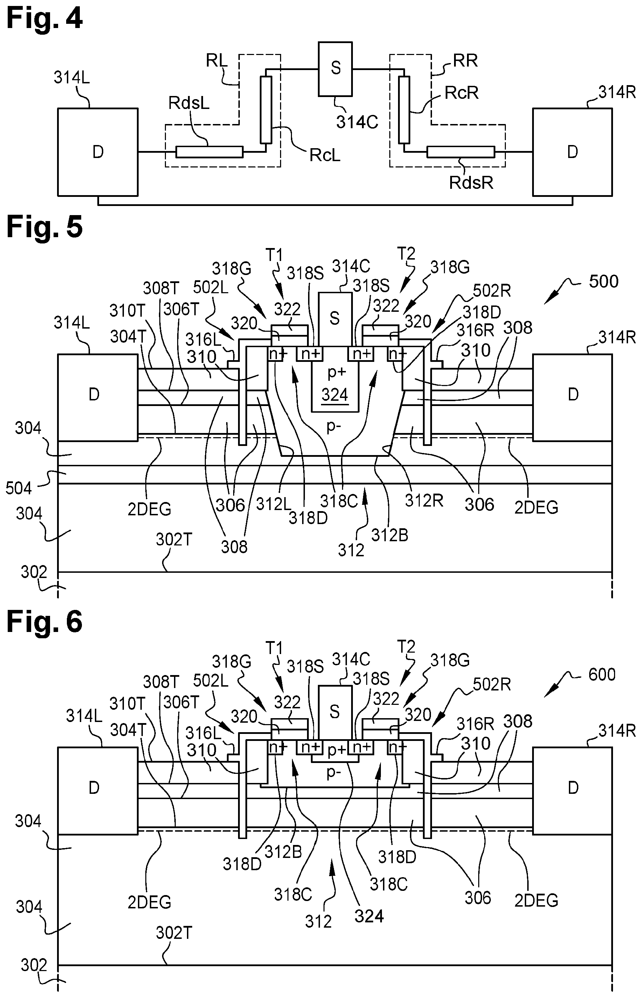

La figure 4 est un schéma électrique équivalent au dispositif électronique 300 de la figure 3.

La résistance Ron à l'état passant du dispositif 300, entre ses électrodes 314L, 314R et son électrode 314C, peut être décomposée en deux résistances RL et RR associées en parallèle. Chaque résistance RL, RR comprend plus précisément une association en série :
- d'une résistance RdsL, RdsR correspondant à un chemin de conduction empruntant la partie du gaz d'électrons bidimensionnel 2DEG située entre l'électrode 314L, 314R et la région conductrice 316L, 316R ; et
- d'une autre résistance RcL, RcR correspondant à un chemin de conduction à travers la région 318C de canal du transistor T1, T2.

La résistance RdsL est par exemple sensiblement égale à la résistance RdsR, aux dispersions de fabrication près. De même, la résistance RcL est par exemple sensiblement égale à la résistance RcR, aux dispersions de fabrication près.

Dans le schéma de la figure 4, des résistances de contact ainsi que des résistances correspondant à des chemins de conduction à travers les régions conductrices 316L, 316R, à travers les régions 318D de drain et 318S de source et à travers le puits 324 ne sont pas représentées, ces résistances pouvant par exemple être considérées comme négligeables par rapport aux résistances RdsL, RdsR, RcL et RcR.

Chaque résistance RdsL, RdsR du dispositif 300 est par exemple sensiblement équivalente à la résistance Rgd du transistor 100. Chaque résistance RcL, RcR est inférieure aux résistances Rt1, Rg et Rt2. Cela provient notamment du fait que les chemins de conduction à travers la région 318C présentent une longueur plus faible et une résistivité moindre que les chemins de conduction 118L, 118B et 118R à l'intérieur de la couche 304 en nitrure de gallium. Le dispositif 300 présente ainsi avantageusement une résistance Ron à l'état passant inférieure à celle du transistor 100. En outre, le dispositif 300 permet avantageusement d'éviter les phénomènes de piégeage et d'effondrement du courant précédemment évoqués en relation avec la figure 1.

La figure 5 est une vue en coupe, schématique et partielle, d'un dispositif électronique 500 selon un deuxième mode de réalisation. Le dispositif 500 de la figure 5 comprend des éléments communs avec le dispositif 300 de la figure 3. Ces éléments communs ne seront pas détaillés à nouveau ci-après. Le dispositif 500 de la figure 5 diffère du dispositif 300 de la figure 3 principalement en ce que les régions conductrices 316L et 316R du dispositif 500 ne revêtent pas les flancs 312L et 312R de la région semiconductrice 312.

Plus précisément, dans le dispositif 500, chaque région conductrice 316L, 316R comprend par exemple un via conducteur 502L, 502R pénétrant partiellement à l'intérieur de la couche 304 en nitrure de gallium. Le via 502L, 502R contacte la partie du gaz d'électrons bidimensionnel 2DEG située du côté de l'électrode 314L, 314R. Comme illustré en figure 5, chaque région conductrice 316L, 316R comporte en outre une partie s'étendant sur et en contact avec la région 318D de drain du transistor T1, T2.

Les régions conductrices 316L et 316R du dispositif 500 permettent avantageusement, comme cela a été précédemment décrit en relation avec la figure 3, de faciliter la circulation des électrons entre les parties du gaz d'électrons bidimensionnel 2DEG et les régions 318D de drain des transistors T1 et T2.

Dans l'exemple représenté, le dispositif 500 comporte de manière facultative en outre une couche 504 formée à l'intérieur de la couche 304 en nitrure de gallium. La couche 504 est par exemple une couche isolante dopée du deuxième type de conductivité, dans cet exemple le type p, et appelée couche barrière arrière (« back-barrier », en anglais). À titre d'exemple, la couche 504 est en nitrure d'aluminium-gallium (AlGaN) et présente une teneur en aluminium comprise par exemple entre 10 et 15 %. La couche 504 présente par exemple une épaisseur comprise entre 50 et 100 nm et est située à une distance d'environ 50 nm par rapport à une face inférieure 312B de la région 312.

La présence de la couche 504 dans le dispositif 500 permet avantageusement de confiner les électrons dans une partie de la couche 304 de faible épaisseur, comprise entre la couche 504 et la face supérieure 304T de la couche 304. On évite, ou on limite, ainsi un piégeage en volume des électrons à l'intérieur de la couche 304. En outre, la couche 504 permet avantageusement d'isoler davantage la région semiconductrice 312 par rapport au substrat 302, évitant ou limitant ainsi par exemple l'apparition d'un courant vertical, provenant du substrat 302, consécutif à une interruption du courant circulant entre les électrodes 314L, 314R et l'électrode 314C lorsque le dispositif 500 est commuté de l'état passant à l'état bloqué.

Un autre avantage de ce mode de réalisation tient au fait que les vias conducteurs 502L et 502R peuvent être réalisés indépendamment de la région semiconductrice 312. Cela permet notamment une plus grande liberté dans l'ajustement des dimensions de ces vias. Les vias 502L et 502R et les électrodes 314L et 314R peuvent en outre être avantageusement réalisés au cours d'une même étape, par exemple en fin de réalisation du dispositif 500.

La figure 6 est une vue en coupe, schématique et partielle, d'un dispositif électronique 600 selon un troisième mode de réalisation. Le dispositif 600 de la figure 6 comprend des éléments communs avec le dispositif 500 de la figure 5. Ces éléments communs ne seront pas détaillés à nouveau ci-après. Le dispositif 600 de la figure 6 diffère du dispositif 500 de la figure 5 principalement en ce que la région semiconductrice 312 ne pénètre pas à l'intérieur de la couche 304 en nitrure de gallium.

Plus précisément, dans le dispositif 600, la face inférieure 312B de la région semiconductrice 312 est située au niveau de la couche 308, par exemple sur et en contact avec la face supérieure 308T de la couche 308 ou dans l'épaisseur de la couche 308. La face inférieure 312B de la région 312 est ainsi isolée de la couche 304 en nitrure de gallium par tout ou partie de la couche 308 et par la couche 306. Dans le dispositif 600, la région 312 présente, par rapport aux dispositifs 300 et 500, une épaisseur moindre. Cela permet avantageusement de limiter ou d'éviter des fuites latérales dans la région 312 et d'obtenir un meilleur contrôle électrostatique. L'épaisseur de la région 312 est par exemple adaptée en fonction d'une intensité d'un courant circulant dans le dispositif 600 à l'état passant, c'est-à-dire lorsque les transistors T1 et T2 sont commandés à l'état passant.

Par rapport au dispositif 500, le dispositif 600 est en outre dépourvu de la couche 504 dans l'exemple illustré en figure 6. À titre de variante, la couche 504 peut toutefois être prévue dans le dispositif 600 pour obtenir des avantages similaires à ceux exposés en relation avec la figure 5.

À titre d'exemple, la région semiconductrice 312 est réalisée par un procédé de fabrication de plaquettes de silicium sur isolant (« Silicon On Insulator » - SOI, en anglais), par exemple le procédé connu sous la dénomination commerciale « SMART CUT » de la société SOITEC. Dans ce cas, une couche mince de silicium est par exemple reportée au-dessus de la couche 304, par exemple par collage sur la couche 308. Cette couche mince de silicium est ensuite amincie par meulage, jusqu'à obtenir une épaisseur comprise par exemple entre 50 et 100 nm, puis gravée de façon à former la région 312 de chaque dispositif 600. La région semiconductrice 312 peut ainsi avantageusement être réalisée en un matériau cristallin, par exemple en silicium ou en carbure de silicium cristallin, à l'intérieur duquel la mobilité des électrons est supérieure du fait d'une faible présence de défauts. Cela permet de réduire encore davantage la résistance Ron à l'état passant du dispositif 600.

Un autre avantage du dispositif 600 tient au fait qu'une partie du gaz d'électrons bidimensionnel 2DEG est présente sous la région semiconductrice 312, entre les deux vias conducteurs 502L et 502R. Cela permet de dépléter, par effet électrostatique, la région 312 dopée de type p. Il en résulte que la tension de seuil du dispositif 600 est accrue notamment par rapport au dispositif 500.

À titre de variante, la région semiconductrice 312 peut dans ce cas être non dopée, à l'exception des régions 318S et 318D et éventuellement du puits 324, du fait de la présence du gaz d'électrons bidimensionnel 2DEG sous la région 312. Les régions 318C de canal des transistors T1 et T2 sont dans ce cas non dopées.

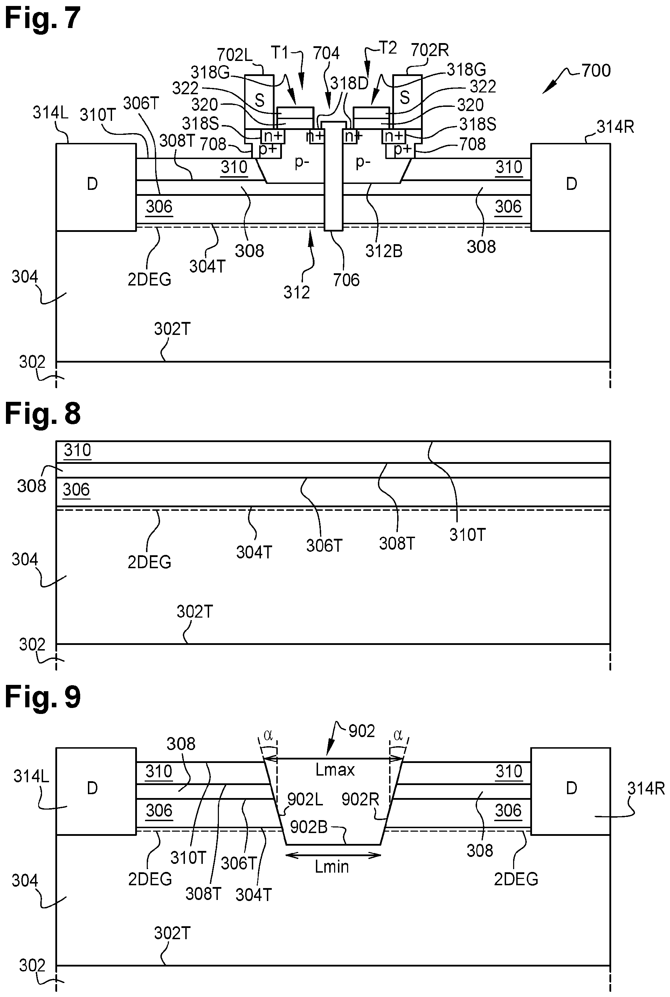

La figure 7 est une vue en coupe, schématique et partielle, d'un dispositif électronique 700 selon un quatrième mode de réalisation non couvert par les revendications. Le dispositif 700 de la figure 7 comprend des éléments communs avec le dispositif 600 de la figure 6. Ces éléments communs ne seront pas détaillés à nouveau ci-après.

Le dispositif 700 de la figure 7 diffère du dispositif 600 de la figure 6 principalement en ce que le dispositif 700 comprend deux électrodes 702L (S) et 702R (S) portées par la région semiconductrice 312 et situées de part et d'autre des transistors T1 et T2 sur et en contact avec les régions 318S de source de ces transistors. En outre, dans le dispositif 700, le gaz d'électrons bidimensionnel 2DEG est connecté électriquement aux régions 318D de drain des transistors T1 et T2 par une seule région conductrice 704. La région 704 comprend par exemple un via conducteur 706 traversant intégralement la région 312, la couche 308 et la couche 306 et pénétrant partiellement à l'intérieur de la couche 304 en nitrure de gallium. Afin d'obtenir des résistances de contact faibles, la région conductrice 704 peut, comme illustré en figure 7, comporter une partie s'étendant latéralement sur et en contact avec les régions 318D de drain des transistors T1 et T2, les transistors T1 et T2 étant situés de part et d'autre du via conducteur 706.

Dans l'exemple représenté, les régions 318S de source des transistors T1 et T2 sont séparées de la face supérieure 310T de la couche 310 par des régions 708 fortement dopées du deuxième type de conductivité, ici le type p (p+). Les régions 708 situées de part et d'autre du via conducteur 706 contactent respectivement les électrodes 702L et 702R. Les régions 708 contribuent à maintenir le potentiel de la partie de la couche 312 faiblement dopée de type p (p-) à la valeur du potentiel de source. En variante, les régions 708 sont omises.

Un avantage du dispositif 700 tient au fait que les électrodes 702L et 702R assurent une meilleure répartition de courant. Cela permet ainsi de limiter ou d'éviter un échauffement du dispositif 700 à l'état passant.

Les figures 8 à 15 ci-dessous illustrent des étapes successives d'un exemple d'un mode de mise en œuvre d'un procédé de réalisation du dispositif 300 de la figure 3.

La figure 8 est une vue en coupe, schématique et partielle, illustrant une étape du mode de mise en œuvre du procédé de réalisation du dispositif 300 de la figure 3.

Au cours de cette étape, les couches 304, 306, 308 et 310 sont successivement réalisées, dans cet ordre, du côté de la face 302T du substrat 302. Plus précisément :
- la couche 304 s'étend de façon continue et sur toute la face 302T supérieure du substrat 302 ;
- la couche 306 s'étend de façon continue et sur toute la face supérieure 304T de la couche 304 ;
- la couche 308 s'étend de façon continue et sur toute la face supérieure 306T de la couche 306 ; et
- la couche 310 s'étend de façon continue et sur toute la face supérieure 308T de la couche 308.

Les couches 304, 306, 308 et 310 sont par exemple réalisées par épitaxie. Bien que cela ne soit pas représenté en figure 8, une couche intermédiaire en nitrure d'aluminium (AlN) peut être intercalée entre les couches 304 et 306. Le cas échéant, cela permet de favoriser l'épitaxie de la couche 306 en nitrure d'aluminium-gallium sur la couche 304 en nitrure de gallium par adaptation de paramètre de maille.

En figure 8, le gaz d'électrons bidimensionnel 2DEG s'étend latéralement et de façon continue dans la couche 304, sous la face supérieure 304T de la couche 304.

La figure 9 est une vue en coupe, schématique et partielle, illustrant une étape ultérieure du mode de mise en œuvre du procédé de réalisation du dispositif 300 de la figure 3.

Au cours de cette étape, on réalise une tranchée 902 s'étendant verticalement en direction du substrat 302 depuis la face supérieure 310T de la couche 310. Plus précisément, dans l'exemple représenté, la tranchée 902 traverse les couches 310, 308 et 306 et pénètre partiellement dans l'épaisseur de la couche 304. La tranchée 902 s'arrête dans la couche 304 et n'atteint pas la face supérieure 302T du substrat 302.

À titre d'exemple, la tranchée 902 est réalisée par gravure de couches atomiques (« Atomic Layer Etching » - ALE, en anglais).

La tranchée 902 présente des parois latérales 902L et 902R et un fond 902B qui correspondent respectivement aux flancs 312L et 312R et au fond 312B de la future région semiconductrice 312 du dispositif 300.

Dans l'exemple représenté, les parois latérales 902L et 902R de la tranchée 902 sont obliques. Plus précisément, la tranchée 902 est par exemple gravée de sorte que ses parois latérales 902L et 902R forment chacune un angle α par rapport à une normale à la face supérieure 310T de la couche 310. À titre d'exemple, l'angle α formé par les parois 902L et 902R est compris entre 5° et 45°, par exemple égal à environ 10°. La tranchée 902 présente ainsi un profil évasé comportant une ouverture (en haut, dans l'orientation de la figure 9) plus large que son fond 902B (en bas, dans l'orientation de la figure 9). L'inclinaison des parois latérales 902L et 902R de la tranchée 902 résulte par exemple d'une étape de gravure chimique isotrope. À titre de variante, la tranchée 902 peut présenter des parois latérales 902L et 902R sensiblement verticales, c'est-à-dire dont l'angle α est égal à environ 0°.

À titre d'exemple, la tranchée 902 présente :
- une largeur maximale Lmax comprise entre 0,4 et 1 µm, par exemple égale à environ 0,5 µm ; et
- une largeur minimale Lmin comprise entre 0,2 et 0,4 µm, par exemple égale à environ 0,3 µm.

En variante, les parois latérales 902L et 902R de la tranchée 902 sont sensiblement verticales, l'angle α étant dans ce cas égal à environ 0°.

Les électrodes 314L et 314R sont ensuite formées de part et d'autre de la tranchée 902. À titre d'exemple, les électrodes 314L et 314R sont obtenues par dépôt puis gravure locale d'une couche métallique (non représentée) revêtant la face supérieure de la couche 310.

À l'issue de cette étape, le gaz d'électrons bidimensionnel 2DEG est discontinu. Plus précisément, la tranchée 902 sépare le gaz d'électrons bidimensionnel 2DEG en deux parties situées de part et d'autre de la tranchée 902. Les couches 306, 308 et 310 sont en outre séparées chacune en deux parties de couches disjointes situées de part et d'autre de la tranchée 902.

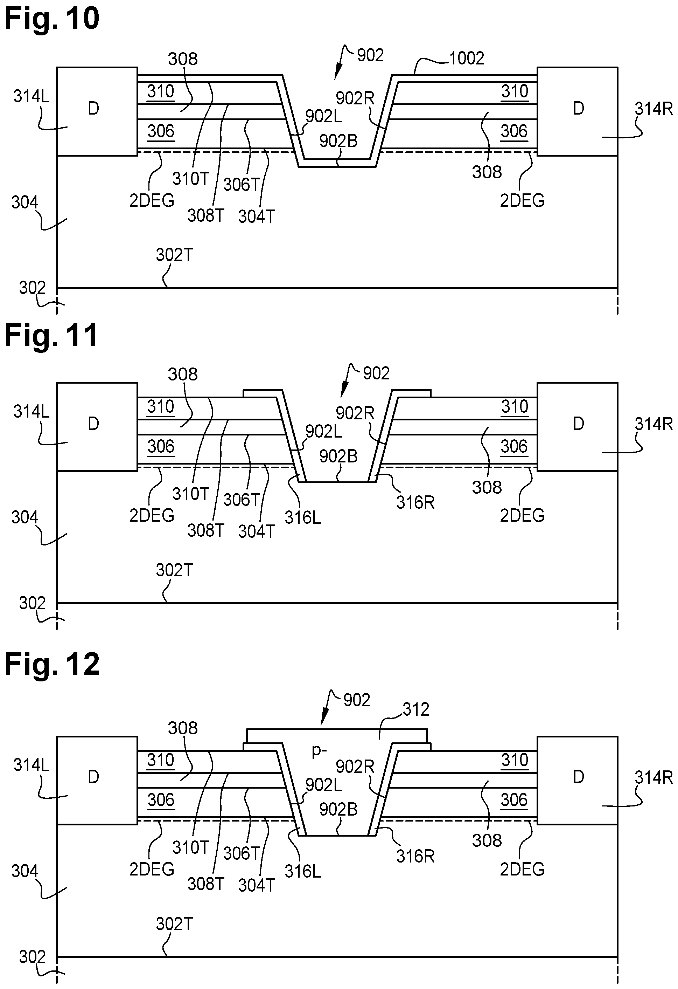

La figure 10 est une vue en coupe, schématique et partielle, illustrant encore une étape ultérieure du mode de mise en œuvre du procédé de réalisation du dispositif 300 de la figure 3.

Au cours de cette étape, une couche conductrice 1002 est déposée sur la structure. La couche conductrice 1002 revêt la face supérieure 310T des parties de la couche 310 ainsi que les parois latérales 902L, 902R et le fond 902B de la tranchée 902.

À titre d'exemple, la couche conductrice 1002 est réalisée par une technique de dépôt conforme, par exemple par dépôt chimique en phase vapeur (« Chemical Vapor Deposition » - CVD, en anglais). On évite, ou on limite, ainsi la présence de défauts cristallins à l'interface entre les couches 304 et 1002, ces défauts étant susceptibles de former des états pièges pour les électrons.

La figure 11 est une vue en coupe, schématique et partielle, illustrant encore une étape ultérieure du mode de mise en œuvre du procédé de réalisation du dispositif 300 de la figure 3.

Au cours de cette étape, la couche conductrice 1002 est gravée de sorte à exposer le fond 902B de la tranchée 902. On élimine pour cela une partie de la couche 1002 revêtant le fond 902B de la tranchée 902. La couche 1002 est ainsi séparée en deux parties disjointes. On obtient plus précisément, à l'issue de la gravure, les régions conductrices 316L et 316R revêtant respectivement les parois 902L et 902R de la tranchée 902. Étant donné que les électrodes 314L et 314R sont à un même potentiel, on peut alternativement prévoir une région conductrice d'un seul tenant, c'est-à-dire revêtant de façon continue les flancs 902L, 902R et le fond 902B de la tranchée 902.

Dans l'exemple représenté, la couche 1002 est en outre gravée du côté des électrodes 314L et 314R, c'est-à-dire à gauche et à droite dans l'orientation de la figure 11, de sorte à exposer des parties de la face supérieure 310T de la couche 310 situées entre les électrodes 314L, 314R et la future région semiconductrice 312.

À titre d'exemple, les régions conductrices 316L et 316R sont réalisées par un procédé de gravure humide de la couche 1002. Cela permet notamment d'obtenir une faible rugosité au niveau du fond 902B de la tranchée 902.

La gravure humide peut être précédée d'une étape de gravure sèche, par exemple assistée par plasma. Dans ce cas, la gravure humide permet une amélioration d'état de surface, obtenu à l'issue de l'étape de gravure sèche, du fond 902B de la tranchée 902.

La figure 12 est une vue en coupe, schématique et partielle, illustrant encore une étape ultérieure du mode de mise en œuvre du procédé de réalisation du dispositif 300 de la figure 3.

Au cours de cette étape, on réalise la région semiconductrice 312 à l'intérieur de la tranchée 902. Dans l'exemple représenté, la région 312 remplit intégralement la tranchée 902 et se prolonge latéralement sur et en contact avec une face supérieure des parties des régions conductrices 316L et 316R situées au-dessus des parties de la couche 310.

La région semiconductrice 312 est par exemple réalisée par une technique de dépôt conforme, par exemple par dépôt chimique en phase vapeur (CVD) de silicium polycristallin faiblement dopé de type p (p-).

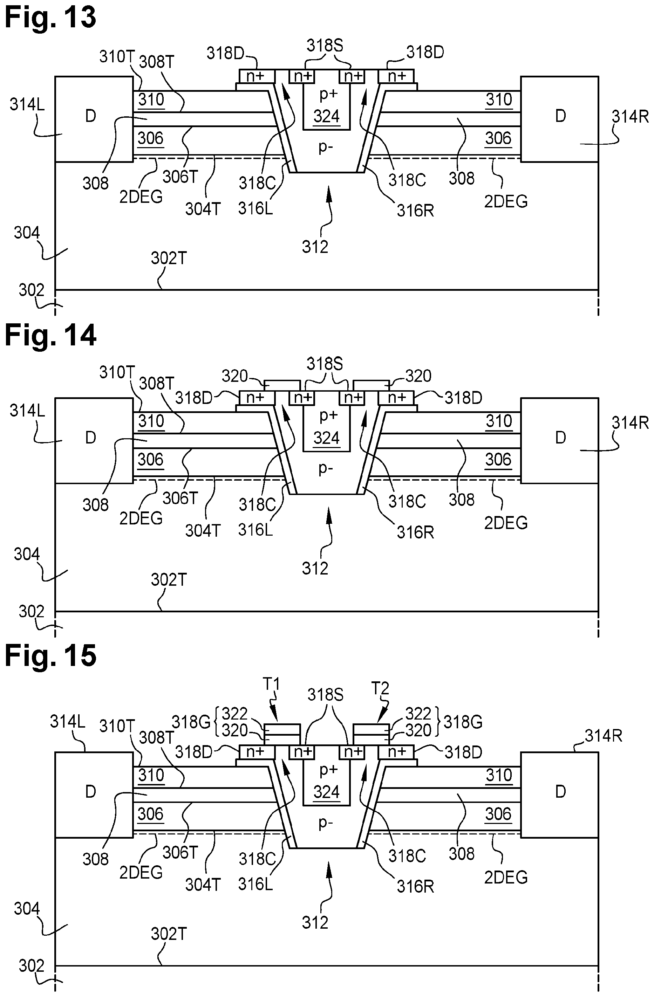

La figure 13 est une vue en coupe, schématique et partielle, illustrant encore une étape ultérieure du mode de mise en œuvre du procédé de réalisation du dispositif 300 de la figure 3.

Au cours de cette étape, la région semiconductrice 312 est dopée pour former les régions 318D et 318S des futurs transistors MOS T1 et T2 et le puits 324. À titre d'exemple, le dopage de la région 312 est effectué par implantation ionique.

La figure 14 est une vue en coupe, schématique et partielle, illustrant encore une étape ultérieure du mode de mise en œuvre du procédé de réalisation du dispositif 300 de la figure 3.

Au cours de cette étape, l'oxyde de grille 320 de chaque futur transistor MOS T1, T2 est réalisé sur et en contact avec les régions 318D de drain, 318C de canal et 318S de source du transistor. À titre d'exemple, une couche d'oxyde, par exemple d'alumine (Al₂O₃), présentant une épaisseur comprise entre 10 et 30 nm est déposée sur la structure puis gravée de sorte à former les oxydes de grille 320 des futurs transistors MOS T1 et T2.

La figure 15 est une vue en coupe, schématique et partielle, illustrant encore une étape ultérieure du mode de mise en œuvre du procédé de réalisation du dispositif 300 de la figure 3.

Au cours de cette étape, l'électrode 322 de grille de chaque transistor MOS T1, T2 est réalisée sur et en contact avec l'oxyde de grille 320 correspondant. À titre d'exemple, une couche conductrice, par exemple en un alliage de nitrure de titane (TiN) et de tungstène (W), est déposée sur la structure puis gravée de sorte à former les électrodes 322 de grille des transistors MOS T1 et T2.

À partir de la structure décrite en relation avec la figure 15, on réalise ensuite l'électrode 314C afin d'obtenir le dispositif 300 exposé en relation avec la figure 3. À titre d'exemple, l'électrode 314C est obtenue par dépôt puis gravure locale d'une couche métallique (non représentée) revêtant la structure. L'électrode 314C du dispositif 300 (figure 3) est plus précisément formée sur et en contact avec une face supérieure du puits 324 préalablement formé à l'intérieur de la région semiconductrice 312.

Divers modes de réalisation, modes de mise en œuvre et variantes ont été décrits. La personne du métier comprendra que certaines caractéristiques de ces divers modes de réalisation, modes de mise en œuvre et variantes pourraient être combinées, et d'autres variantes apparaîtront à la personne du métier.

À partir des indications ci-dessus, la personne du métier est notamment capable de prévoir des dispositifs analogues aux dispositifs 300, 600 et 700 mais comportant une couche isolante analogue à la couche 504 du dispositif 500 à l'intérieur de la couche 304 en nitrure de gallium.

En outre, l'adaptation du procédé de réalisation du dispositif 300 décrit en relation avec les figures 8 à 15 afin d'obtenir les dispositifs 500, 600 et 700 des figures respectivement 6, 7 et 8, ainsi que les dispositifs des autres modes de réalisation et variantes mentionnés dans la présente description, est également à la portée de la personne du métier.

Enfin, la mise en œuvre pratique des modes de réalisation, modes de mise en œuvre et variantes décrits est à la portée de la personne du métier à partir des indications fonctionnelles données ci-dessus. En particulier, la personne du métier est capable de choisir les matériaux des régions conductrices 316L, 316R et 704, ainsi que les taux de dopage de chacune des régions 312, 318S, 318D, 708 et du puits 324 en fonction de l'application visée.

## Revendications

1. Dispositif électronique (300 ; 500 ; 600 ; 700) comportant :
- une région semiconductrice (312) située sur une couche (304) en nitrure de gallium et pénétrant partiellement dans ladite couche ;
- deux électrodes (314L, 314R), situées de part et d'autre et non en contact avec la région semiconductrice, les électrodes pénétrant partiellement dans la couche en nitrure de gallium et étant connectées à la région semiconductrice par l'intermédiaire d'un gaz d'électrons bidimensionnel, 2DEG ; et
- deux transistors MOS latéraux (T1, T2) formés dans et sur la région semiconductrice (312) et connectés en série entre les deux électrodes (314L, 314R).

2. Dispositif selon la revendication 1, dans lequel chaque transistor (T1, T2) est configuré pour commander le passage d'un courant électrique entre l'une desdites électrodes (314L, 314R) et une ou plusieurs deuxièmes électrodes (314C ; 702L, 702R) portées par la région semiconductrice (312) et dans lequel une région de drain (318D) de chaque transistor (T1, T2) est reliée, par l'intermédiaire du gaz d'électrons bidimensionnel, 2DEG, à l'une desdites électrodes (314L, 314R), le dispositif comportant en outre une ou plusieurs régions conductrices (316L, 316R ; 704) contactant les régions de drain des transistors et pénétrant partiellement dans la couche en nitrure de gallium.

3. Dispositif selon la revendication 2, dans lequel chaque transistor (T1, T2) comprend une région de grille (318G) située à l'aplomb d'une région de canal (318C) comprise entre des régions de source (318S) et les régions de drain (318D) formées dans la région semiconductrice (312).

4. Dispositif selon la revendication 3, dans lequel les régions de source (318S) des transistors (T1, T2) sont dopées d'un premier type de conductivité et séparées par un puits (324) formé dans la région semiconductrice (312) et dopé d'un deuxième type de conductivité, opposé au premier type de conductivité.

5. Dispositif selon l'une quelconque des revendications 2 à 4, comportant exactement deux régions conductrices (316L, 316R) revêtant des flancs opposés (312L, 312R) de la région semiconductrice (312) situés en regard desdites électrodes (314L, 314R) et une seule deuxième électrode (314C) située entre les transistors (T1, T2).

6. Dispositif selon l'une quelconque des revendications 2 à 4, comportant exactement deux régions conductrices (316L, 316R) comprenant des vias conducteurs (502L, 502R) situés de part et d'autre de la région semiconductrice (312) et une seule deuxième électrode (314C) située entre les transistors (T1, T2).

7. Dispositif selon l'une quelconque des revendications 1 à 6, dans lequel une partie inférieure (312B) de la région semiconductrice (312) est isolée de la couche (304) en nitrure de gallium.

8. Dispositif selon l'une quelconque des revendications 1 à 7, dans lequel les premières électrodes (314L, 314R) sont destinées à être portées à un même potentiel.

9. Dispositif selon l'une quelconque des revendications 1 à 8, dans lequel la région semiconductrice (312) est en un matériau différent de celui de la couche en nitrure de gallium (304), de préférence en silicium ou en carbure de silicium.

10. Procédé de réalisation d'un dispositif (300 ; 500 ; 600 ; 700) selon l'une quelconque des revendications 1 à 9, le procédé comprenant les étapes suivantes :
a) former une tranchée (902) à l'intérieur de la couche (304) en nitrure de gallium ;
b) former les premières électrodes (314L, 314R) de part et d'autre de la tranchée ;
c) remplir la tranchée par la région semiconductrice (312) ; et
d) former les transistors MOS (T1, T2).

11. Procédé selon la revendication 10 de réalisation d'un dispositif selon la revendication 2, comprenant en outre, après l'étape d), l'étape de former la ou les deuxièmes électrodes (314C ; 702L, 702R).

12. Procédé selon la revendication 10 ou 11 de réalisation d'un dispositif selon la revendication 2, dans lequel la ou les régions conductrices (316L, 316R ; 704) sont formées à l'étape b).

## Patentansprüche

1. Elektronische Einrichtung (300; 500; 600; 700), das Folgendes aufweist:
- einen Halbleiterbereich (312), der auf einer Galliumnitridschicht (304) angeordnet ist und teilweise in diese Schicht eindringt;
- zwei Elektroden (314L, 314R), die auf beiden Seiten des Halbleiterbereichs angeordnet sind und nicht in Kontakt mit dem Halbleiterbereich stehen, wobei die Elektroden teilweise in die Galliumnitridschicht eindringen und über ein zweidimensionales Elektronengas, 2DEG, mit dem Halbleiterbereich verbunden sind; und
- zwei laterale MOS-Transistoren (T1, T2), die innerhalb und auf dem Halbleiterbereich (312) ausgebildet sind und zwischen den zwei Elektroden (314L, 314R) in Reihe geschaltet sind.

2. Einrichtung nach Anspruch 1, wobei jeder Transistor (T1, T2) eingerichtet ist zum Steuern des Fließens eines elektrischen Stroms zwischen einer der genannten Elektroden (314L, 314R) und einer oder einer Vielzahl von zweiten Elektroden (314C; 702L, 702R), die von dem Halbleiterbereich (312) getragen werden, und wobei ein Drainbereich (318D) jedes Transistors (T1, T2) über das zweidimensionale Elektronengas, 2DEG, mit einer der genannten Elektroden (314L, 314R) gekoppelt ist, wobei die Einrichtung ferner eine oder eine Vielzahl von leitfähigen Bereichen (316L, 316R; 704) aufweist, die die Drainbereiche der Transistoren kontaktieren und teilweise in die Galliumnitridschicht eindringen.

3. Einrichtung nach Anspruch 2, wobei jeder Transistor (T1, T2) einen Gatebereich (318G) aufweist, der vertikal in einer Linie mit einem Kanalbereich (318C) angeordnet ist, der zwischen Sourcebereichen (318S) und den Drainbereichen (318D) liegt, die in dem Halbleiterbereich (312) ausgebildet sind.

4. Einrichtung nach Anspruch 3, wobei die Sourcebereiche (318S) der Transistoren (T1, T2) mit einem ersten Leitfähigkeitstyp dotiert und durch eine Wanne (324) getrennt sind, die in dem Halbleiterbereich (312) ausgebildet und mit einem zweiten Leitfähigkeitstyp dotiert ist, der dem ersten Leitfähigkeitstyp entgegengesetzt ist.

5. Einrichtung nach einem der Ansprüche 2 bis 4, aufweisend genau zwei leitfähige Bereiche (316L, 316R), die gegenüberliegende Seiten (312L, 312R) des Halbleiterbereichs (312) beschichten, die vor den besagten Elektroden (314L, 314R) angeordnet sind, und eine einzige zweite Elektrode (314C), die zwischen den Transistoren (T1, T2) angeordnet ist.

6. Einrichtung nach einem der Ansprüche 2 bis 4, aufweisend genau zwei leitfähige Bereiche (316L, 316R), die leitfähige Durchkontaktierungen (502L, 502R) aufweisen, die auf beiden Seiten des Halbleiterbereichs (312) angeordnet sind, und eine einzige zweite Elektrode (314C), die zwischen den Transistoren (T1, T2) angeordnet ist.

7. Einrichtung nach einem der Ansprüche 1 bis 6, wobei ein unterer Abschnitt (312B) des Halbleiterbereichs (312) von der Galliumnitridschicht (304) isoliert ist.

8. Einrichtung nach einem der Ansprüche 1 bis 7, wobei die ersten Elektroden (314L, 314R) dazu bestimmt sind, auf dasselbe Potential gebracht zu werden.

9. Einrichtung nach einem der Ansprüche 1 bis 8, wobei der Halbleiterbereich (312) aus einem Material hergestellt ist, das sich von dem der Galliumnitridschicht (304) unterscheidet, vorzugsweise aus Silizium oder aus Siliziumkarbid.

10. Verfahren zum Ausbilden einer Einrichtung (300; 500; 600; 700) nach einem der Ansprüche 1 bis 9, wobei das Verfahren die folgenden Schritte aufweist:
a) Ausbilden eines Grabens (902) innerhalb der Galliumnitridschicht (304);
b) Ausbilden der ersten Elektroden (314L, 314R) auf beiden Seiten des Grabens;
c) Füllen des Grabens mit dem Halbleiterbereich (312);
d) Ausbilden der MOS-Transistoren (T1, T2).

11. Verfahren nach Anspruch 10 zum Ausbilden einer Einrichtung nach Anspruch 2, ferner aufweisend, nach Schritt d), den Schritt des Ausbildens der zweiten Elektrode(n) (314C; 702L, 702R).

12. Verfahren nach Anspruch 10 oder 11 zum Ausbilden einer Einrichtung nach Anspruch 2, wobei die leitfähige Region oder die leitfähigen Regionen (316L, 316R; 704) in Schritt b) ausgebildet werden.

## Claims

1. Electronic device (300; 500; 600; 700) comprising:
- a semiconductor region (312) located on a gallium nitride layer (304) and partially penetrating into said layer;
- two electrodes (314L, 314R), located on either side of and not in contact with the semiconductor region, the electrodes partially penetrating into the gallium nitride layer and being connected to the semiconductor region via a two-dimensional electron gas, 2DEG; and
- two lateral MOS transistors (T1, T2) formed inside and on top of the semiconductor region (312) and connected in series between the two electrodes (314L, 314R).

2. Device according to claim 1, wherein each transistor (T1, T2) is configured to control the flowing of an electric current between one of said electrodes (314L, 314R) and one or a plurality of second electrodes (314C; 702L, 702R) supported by the semiconductor region (312) and wherein a drain region (318D) of each transistor (T1, T2) is coupled, via the two-dimensional electron gas, 2DEG, to one of said electrodes (314L, 314R), the device further comprising one or a plurality of conductive regions (316L, 316R; 704) contacting the drain regions of the transistors and partially penetrating into the gallium nitride layer.

3. Device according to claim 2, wherein each transistor (T1, T2) comprises a gate region (318G) located vertically in line with a channel region (318C) located between source regions (318S) and the drain regions (318D) formed in the semiconductor region (312).

4. Device according to claim 3, wherein the source regions (318S) of the transistors (T1, T2) are doped with a first conductivity type and separated by a well (324) formed in the semiconductor region (312) and doped with a second conductivity type, opposite to the first conductivity type.

5. Device according to any one of claims 2 to 4, comprising exactly two conductive regions (316L, 316R) coating opposite sides (312L, 312R) of the semiconductor region (312) located in front of said electrodes (314L, 314R) and a single second electrode (314C) located between the transistors (T1, T2).

6. Device according to any one of claims 2 to 4, comprising exactly two conductive regions (316L, 316R) comprising conductive vias (502L, 502R) located on either side of the semiconductor region (312) and a single second electrode (314C) located between the transistors (T1, T2) .

7. Device according to any one of claims 1 to 6, wherein a lower portion (312B) of the semiconductor region (312) is insulated from the gallium nitride layer (304).

8. Device according to any one of claims 1 to 7, wherein the first electrodes (314L, 314R) are intended to be taken to a same potential.

9. Device according to any one of claims 1 to 8, wherein the semiconductor region (312) is made of a material different from that of the gallium nitride layer (304), preferably of silicon or of silicon carbide.

10. Method of forming a device (300; 500; 600; 700) according to any one of claims 1 to 9, the method comprising the steps of:
a) forming a trench (902) inside of the gallium nitride layer (304);
b) forming the first electrodes (314L, 314R) on either side of the trench;
c) filling the trench with the semiconductor region (312);
d) forming the MOS transistors (T1, T2).

11. Method according to claim 10 of forming a device according to claim 2, further comprising, after step d), the step of forming the second electrode(s) (314C; 702L, 702R).

12. Method according to claim 10 or 11 of forming a device according to claim 2, wherein the conductive region(s) (316L, 316R; 704) are formed at step b).
